# FASCICULE DE BREVET EUROPEEN

(11) **EP 1 482 559 B1**
(45) Date de publication et mention de la délivrance du brevet: **07.04.2010**
(21) Numéro de dépôt: 04354021.0
(22) Date de dépôt: 11.05.2004
(51) Int. Cl.: H01L 27/146, H01L 31/18

(54) **Détecteur de rayonnement infrarouge photovoltaique à grille conductrice indépendante et tridimensionnelle**
Infrarotdetektor mit unabhängigem, leitfähigem 3D-Gate
Infrared detector with independent, conductive, tridimensional gate

(30) Priorité: 26.05.2003 FR 0306324
(43) Date de publication de la demande: 01.12.2004
(73) Titulaire: COMMISSARIAT A L'ENERGIE ATOMIQUE, 75752 Paris Cédex 15 (FR)
(72) Inventeur: Gravrand, Olivier, 38120 Fontanil-Cornillon (FR); Baylet, Jacques, 38000 Grenoble (FR)
(74) Mandataire: Hecké, Gérard

(56) Documents cités:
- EP-A- 0 428 159
- EP-A- 0 601 200
- EP-A- 0 747 962
- EP-A- 0 797 255
- EP-A- 1 028 470
- EP-A- 1 265 296
- US-A- 5 952 703

## Description

### Domaine technique de l'invention

L'invention concerne un détecteur de rayonnement infrarouge photovoltaïque comportant, sur une face avant d'un substrat transparent au rayonnement considéré, un empilement de couches en matériaux semi-conducteurs absorbants, un réseau de canaux délimitant dans l'empilement de couches des pixels, et une couche isolante recouvrant au moins le fond et les flancs des canaux.

### État de la technique

Un détecteur de rayonnement infrarouge multispectral photovoltaïque à semi-conducteur est typiquement constitué d'un circuit de détection et d'un circuit de lecture :
- Le circuit de détection est réalisé dans un matériau semi-conducteur, absorbant le rayonnement dans une ou plusieurs bandes infrarouges de longueurs d'onde de coupure distinctes, et comporte des photodiodes collectant le courant des photo-porteurs générés.
- Le circuit de lecture réalise un multiplexage des photodiodes du circuit de détection ou une interconnexion du circuit de détection avec un circuit extérieur.

La présente invention concerne le circuit de détection d'un tel détecteur.

Plusieurs types de détection multispectrale peuvent être distingués, notamment une détection à cohérence temporelle, à cohérence spatiale ou à cohérence spatio-temporelle :
- La détection à cohérence temporelle est obtenue lorsque l'acquisition des différentes bandes spectrales est effectuée simultanément. Ceci nécessite au moins une connexion électrique par bande spectrale.
- La détection à cohérence spatiale est obtenue par un réseau de pixels séparés, comportant chacun plusieurs zones sensibles semi-conductrices correspondant aux différentes bandes spectrales, superposées et centrées les unes par rapport aux autres. A chaque zone sensible est associée une photodiode qui est typiquement constituée par une jonction du type PN. La cohérence spatiale est obtenue lorsque les volumes de collection des différentes jonctions sont centrés les uns par rapport aux autres. Chaque jonction doit être séparée électriquement des jonctions des pixels voisins.
- La détection de type cohérence spatio-temporelle est obtenue par la combinaison des deux cas précédents et impose les contraintes précédentes sur un même circuit.

Le document EP-A-0 747 962 décrit en detecteur infrarouge avec un réseau de canaux.

Les détecteurs sont en général sous forme matricielle (d'une ou plusieurs colonnes), les points élémentaires sont appelés pixels. Ces pixels sont des zones définies à la surface du détecteur qui sont dédiées soit à la détection (pixel dit « actif ») soit à d'autres fonctions (pixel dit « inactif ») comme la reprise du contact substrat. Généralement les pixels sont séparés physiquement les uns des autres par des zones de séparation inter-pixel, créées par gravure de canaux dans le matériau entre les pixels voisins, puis dépôt d'un isolant sur la surface du matériau. La gravure des canaux engendre plusieurs problèmes :
- Les canaux entre des pixels voisins étant en général de largeur non-négligeable en regard de la largeur des pixels, il s'ensuit une perte de surface utile et du rendement quantique du détecteur.
- Des fuites possibles des photons par les flancs ou le fond des canaux et des réflexions à l'extérieur du détecteur peuvent introduire une diaphotie extra-pixel (détection d'un photon destiné à un pixel par un pixel voisin) ou intra-pixel (détection d'un photon destiné à une bande spectrale dans une zone sensible correspondant à une autre bande spectrale).
- Le procédé de gravure dégrade généralement les propriétés électriques du matériau absorbant à proximité des flancs des canaux.

### Objet de l'invention

L'invention a pour but de remédier à ces inconvénients et, en particulier, d'optimiser le rendement quantique et de minimiser la diaphotie d'un détecteur de rayonnement infrarouge photovoltaïque à semi-conducteur.

Selon l'invention, ce but est atteint par les revendications annexées et, plus particulièrement, par le fait que le détecteur comporte une couche électriquement conductrice recouvrant la couche isolante au fond et sur les flancs des canaux et électriquement indépendante des matériaux semi-conducteurs, de manière à être totalement isolée électriquement des matériaux semi-conducteurs par ladite couche isolante.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 et 2 représentent un mode de réalisation particulier d'un détecteur selon l'invention, respectivement en coupe selon l'axe AA et en vue de dessus.
La figure 3 représente un mode de réalisation particulier d'un pixel d'un détecteur selon l'invention.

### Description de modes particuliers de réalisation

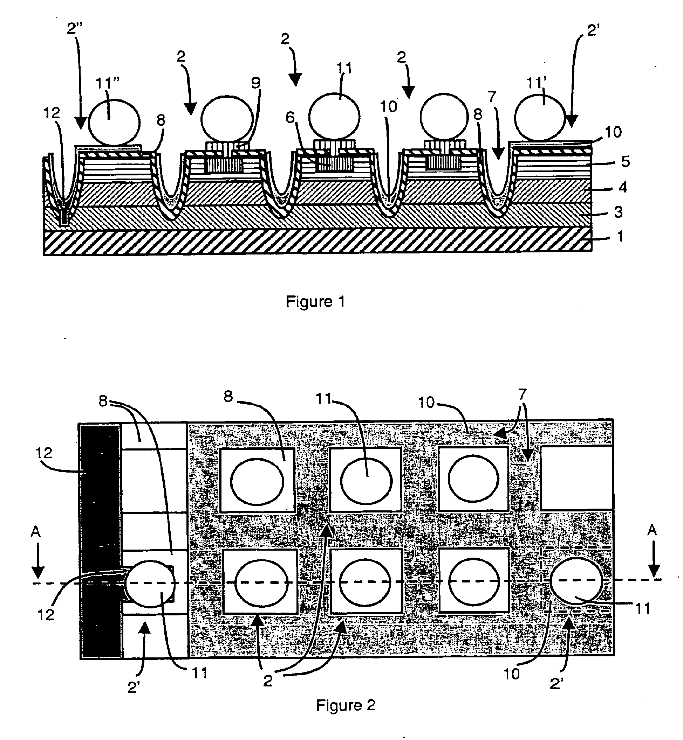

Les figures 1 et 2 représentent un détecteur de rayonnement infrarouge photovoltaïque permettant une détection à cohérence spatiale. Un réseau de pixels actifs 2 et inactifs (2', 2") est disposé sur une face avant d'un substrat 1 transparent au rayonnement considéré. Chaque pixel est délimité dans un empilement de couches 3-6 en matériaux semi-conducteurs absorbants, et séparé des pixels voisins par des canaux 7, sensiblement concaves, creusés dans l'empilement de couches 3-6 de manière à former un réseau de canaux 7 communicants perpendiculaires les uns aux autres (figure 2). Les fonds et les flancs des canaux sont recouverts par une couche isolante 8, qui recouvre également la face avant des pixels inactifs 2' et 2", disposés aux extrémités du détecteur (à gauche et à droite sur les figures 1 et 2).

Les faces avant des pixels actifs 2 sont partiellement recouvertes par la couche isolante 8 sur une première zone, périphérique, de la face avant, laissant au centre de chaque pixel actif 2 une deuxième zone, centrale, qui est recouverte par une couche métallique 9 débordant sur la couche isolante 8 à la périphérie de la zone centrale et permettant de récupérer le signal électrique délivré par le pixel.

Une couche électriquement conductrice 10 recouvre la couche isolante 8 au fond et sur les flancs des canaux 7 d'une majeure partie du réseau de canaux et sur la face avant d'un pixel inactif 2', situé à droite sur les figures 1 et 2. La couche électriquement conductrice 10 constitue ainsi une grille conductrice tridimensionnelle et indépendante des matériaux semi-conducteurs. Sur les pixels sont disposées des bornes de connexion 11 et 11', respectivement en contact avec les couches métalliques 9 disposées sur les pixels actifs 2, et avec la couche conductrice 10, en contact avec le pixel inactif 2' situé à droite sur les figures 1 et 2. La borne 11 permet de gérer électriquement le pixel actif et la borne 11' permet de polariser en tension la couche électriquement conductrice 10. Avantageusement, les bornes 11 et 11' sont identiques.

Le pixel inactif 2" est indépendant du reste de la structure : il permet la reprise du contact des couches internes. Un canal situé à une extrémité du détecteur (à gauche sur les figures 1 et 2) comporte une couche de connexion électrique 12 permettant de polariser la couche arrière 3 de l'empilement de couches 3-6 en matériaux semi-conducteurs. La couche de connexion électrique 12 remplit un orifice traversant la couche isolante 8 au fond du canal d'extrémité adjacent à un pixel inactif 2' et recouvre la couche isolante 8 sur les flancs du canal et en partie sur la face avant du pixel inactif 2'. Ainsi, la couche arrière 3 peut être polarisée par l'intermédiaire d'une borne de connexion 11 associée. La couche de connexion électrique 12 n'est pas en contact électrique avec la couche électriquement conductrice 10.

Les pixels représentés à la figure 1 permettent une détection bi-spectrale, c'est-à-dire la détection de deux bandes spectrales différentes. Les couches absorbantes 3 et 4 ont une longueur d'onde de coupure commune, inférieure aux longueurs d'onde de coupure des couches 5 et 6. A l'interface des couches 3 et 4, d'une part, et à l'interface des couches 5 et 6, d'autre part, des jonctions de type PN sont créées par dopage opposé des couches respectives. Afin d'obtenir un détecteur multispectral, une pluralité de jonctions PN peut être empilée sur la face avant du substrat 1 par ordre croissant de longueur d'onde de coupure des matériaux constituant les jonctions PN. Ainsi, l'empilement des couches en matériaux semi-conducteurs peut être un empilement multiple alternant des couches de dopage N (couches 3 et 6 par exemple) et de dopage P (couches 4 et 5 par exemple), par exemple de type NPPNNP. Dans le mode de réalisation particulier représenté, la couche 6 associée à un pixel actif 2 est formée par dopage de la partie centrale de la couche 5 correspondante.

La lecture du détecteur bi-spectral représenté à la figure 1 est effectuée en appliquant des tensions électriques appropriées entre la couche arrière 3 de l'empilement par l'intermédiaire de la couche de connexion électrique 12, et les bornes 11 des pixels actifs 2.

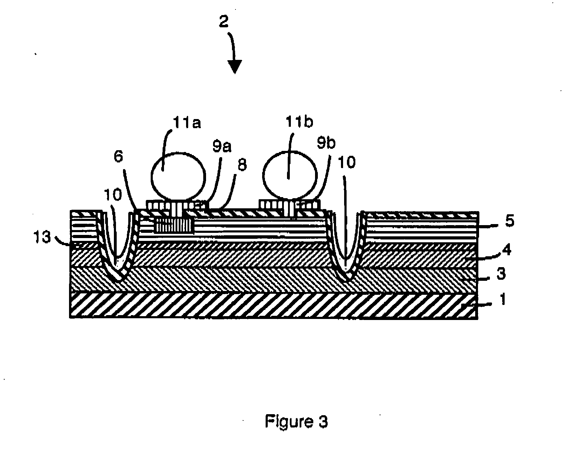

Un autre mode de réalisation particulier d'un pixel actif 2, représenté à la figure 3, permet de distinguer simultanément deux bandes spectrales par l'intermédiaire de deux bornes de connexion 11 a et 11 b associées au même pixel, et, ainsi, une détection à cohérence spatio-temporelle. Une première borne 11a est en contact électrique avec la couche 6, et une deuxième borne 11 b est en contact électrique avec la couche 5, respectivement par l'intermédiaire d'une couche métallique 9a recouvrant une deuxième zone, en contact avec la couche 6, et une couche métallique 9b recouvrant une troisième zone, en contact avec la couche 5, du pixel actif 2. La première borne 11 a permet de polariser la jonction PN correspondant aux couches 5 et 6, tandis que la deuxième borne 11 b permet de polariser la jonction PN correspondant aux couches 3 et 4.

La couche électriquement conductrice 10 présente plusieurs avantages :
- Des photons se propageant en direction de l'espace entre deux pixels voisins sont concentrés sur le centre d'un pixel, ce qui permet d'augmenter le rendement du détecteur. La couche joue le rôle de guide d'onde. Son efficacité dépend de la géométrie des canaux qui doit aussi être adaptée à la géométrie des zones sensibles du pixel.
- Le passage de photons non-absorbés dans l'espace entre les pixels étant limité, les problèmes de diaphotie extra pixel et intra-pixel sont réduits.
- La polarisation de la couche conductrice 10 permet de modifier la configuration du champ électrique à l'intérieur d'un pixel et la structure de bande à proximité des flancs d'un pixel. Ainsi, les photo-porteurs peuvent être repoussés en direction des jonctions, ce qui permet d'augmenter le rendement du détecteur. Une tension optimale peut être choisie en fonction de la géométrie des pixels et des jonctions et en fonction d'autres tensions appliquées au détecteur.

Une procédé de réalisation d'un détecteur de rayonnement infrarouge photovoltaïque bi-spectral selon les figures 1 et 2 comporte le dépôt de l'empilement de couches 3-6 en matériaux semi-conducteurs absorbants sur la face avant du substrat 1. Les matériaux des couches peuvent être, de préférence, du type CdₓHg₁₋ₓTe et être déposées par épitaxie par jets moléculaires, procédé qui permet de contrôler finement l'évolution de la composition d'une couche en fonction de l'épaisseur de l'épitaxie. Une première couche 3 de Cd_{0,4}Hg_{0,6}Te dopé N et une deuxième couche 4 de Cd_{0,4}Hg_{0,6}Te dopé P peuvent former une première jonction PN. Les deux matériaux ayant une longueur d'onde de coupure de 3µm, les couches 3 et 4 permettent de détecter une première bande spectrale. Sur la face avant de la couche 4 est déposée une couche 5 de Cd_{0,3}Hg_{0,7}Te dopé P, permettant d'absorber une deuxième bande spectrale ayant une longueur d'onde de coupure de 5µm.

Dans cette couche 5 une jonction PN est réalisée par une étape d'implantation ionique, de manière à créer, à l'intérieur de la couche 5, une couche 6 dopée N.

L'invention peut s'appliquer à d'autres détecteurs. Par exemple, les détecteurs à base de composés II-VI (comme le CdHgTe) peuvent être intéressant : Cd ZnTe, ZbSe, etc... Les détecteurs à base de composé III-V sont aussi concernés ; ils peuvent être choisis parmi GaAs, InSb, InAsSb, InGaAs, etc... Enfin les sels de plomb peuvent aussi convenir.

L'empilement des couches 3-6 obtenu par les étapes de dépôt et d'implantation couvre uniformément toute la surface du substrat 1. Une gravure de canaux 7 dans l'empilement permet de délimiter le réseau de pixels actifs 2 et inactifs 2'. Une couche isolante 8 est ensuite déposée sur la majeure partie de la surface du détecteur, notamment sur la face avant des pixels, les fonds et les flancs des canaux 7, sauf sur une zone centrale de la face avant des pixels, où une couche métallique 9, 9a ou 9b, est déposée en contact avec la couche 6 ou avec la couche 5 (figure 3) pour relier les pixels aux bornes de connexion 11. Chaque pixel obtenu est constitué de deux photodiodes en opposition (NPPN), dont le fonctionnement est géré par la tension appliquée entre la couche arrière 3 et les bornes de connexion 11. Le pas du réseau de pixels peut être de l'ordre de 30 µm.

Un dépôt métallique permet ensuite d'obtenir la couche électriquement conductrice 10, recouvrant la couche isolante 8 au fond et sur les flancs des canaux d'une partie du réseau sans être en contact avec les parties conductrices (9a, 9b, 12) elles-mêmes en contact avec les couches semi-conductrices. Cette couche électriquement conductrice 10 peut être elle-même un empilement de couches (non-représenté) afin de favoriser son adhérence, sa conductivité, ses propriétés optiques, etc... Elle peut être réalisée à partir de matériaux comme Au, Ti, Al, Pd, Pt, etc...

L'empilement des couches en matériaux semi-conducteurs peut comporter, entre deux jonctions PN, une couche semi-conductrice supplémentaire 13 (figure 3) présentant un gap semi-conducteur supérieur aux gaps desdits matériaux semi-conducteurs et servant ainsi de barrière électrique aux photo-porteurs, ce qui permet de limiter davantage la diaphotie intra-pixel.

Il est à noter que l'épaisseur des couches ayant la longueur d'onde de coupure la plus faible, doit être suffisante pour absorber un maximum de photons de longueur d'onde inférieure afin de limiter une diaphotie directe, c'est-à-dire une détection des photons dans une couche supérieure sans réflexion sur les flancs de gravure ou sur un élément extérieur au circuit de détection.

## Revendications

1. Détecteur de rayonnement infrarouge photovoltaïque comportant, sur une face avant d'un substrat (1) transparent au rayonnement considéré, un empilement de couches (3-6) en matériaux semi-conducteurs absorbants, un réseau de canaux (7) délimitant dans l'empilement de couches (3-6) des pixels (2, 2', 2"), et une couche isolante (8) recouvrant au moins le fond et les flancs des canaux (7), détecteur **caractérisé en ce qu'**il comporte une couche électriquement conductrice (10) recouvrant la couche isolante (8) au fond et sur les flancs des canaux (7) et électriquement indépendante des matériaux semi-conducteurs, de manière à être totalement isolée électriquement des matériaux semi-conducteurs par ladite couche isolante (8).

2. Détecteur selon la revendication 1, **caractérisé en ce que** la couche électriquement conductrice (10) est connectée à une borne de connexion (11').

3. Détecteur selon l'une des revendications 1 et 2, **caractérisé en ce que** la couche isolante (8) recouvre également, au moins partiellement, la face avant d'au moins un pixel (2').

4. Détecteur selon la revendication 3, **caractérisé en ce que** la couche électriquement conductrice (10) recouvre au moins une partie de la couche isolante (8) recouvrant, au moins partiellement, la face avant d'un pixel (2').

5. Détecteur selon la revendication 4, **caractérisé en ce qu'**une borne de connexion (11') est située sur la couche électriquement conductrice (10), à la face avant d'un pixel (2').

6. Détecteur selon l'une quelconque des revendications 1 à 5, **caractérisé en ce que** l'empilement des couches (3-6) en matériaux semi-conducteurs absorbants forme au moins deux jonctions PN ayant des longueurs d'onde de coupure différentes, empilées sur la face avant du substrat (1) par ordre croissant de longueur d'onde de coupure.

7. Détecteur selon l'une quelconque des revendications 1 à 6, **caractérisé en ce que** l'empilement des couches (3-6) en matériaux semi-conducteurs comporte, entre deux jonctions PN, une couche semi-conductrice supplémentaire (13) présentant un gap semi-conducteur supérieur aux gaps desdits matériaux semi-conducteurs.

8. Détecteur selon l'une quelconque des revendications 1 à 7, **caractérisé en ce que** les matériaux semi-conducteurs sont choisis parmi CdHgTe, InSb, InGaAs.

9. Détecteur selon l'une quelconque des revendications 1 à 8, **caractérisé en ce que** la couche électriquement conductrice (10) comprend un empilement de plusieurs couches.

10. Détecteur selon l'une quelconque des revendications 1 à 9, **caractérisé en ce que** la couche électriquement conductrice (10) comprend au moins un matériau choisi parmi Au, Ti, AI, Pt, Pd.

11. Procédé de réalisation d'un détecteur de rayonnement infrarouge photovoltaïque selon l'une quelconque des revendications 1 à 10, comportant le dépôt sur une face avant d'un substrat (1), transparent au rayonnement considéré, d'un empilement de couches (3-6) en matériaux semi-conducteurs absorbants, la délimitation d'un réseau de pixels (2, 2', 2") par gravure de canaux (7) dans l'empilement de couches (3-6) en matériaux semi-conducteurs, le dépôt d'une couche isolante (8), recouvrant au moins le fond et les flancs des canaux (7), et le dépôt d'une couche électriquement conductrice (10) recouvrant la couche isolante (8) au fond et sur les flancs des canaux (7) délimitant au moins une partie des pixels (2, 2', 2").

12. Procédé d'utilisation d'un détecteur de rayonnement infrarouge photovoltaïque selon l'une quelconque des revendication 1 à 10, **caractérisé en ce que** la couche électriquement conductrice (10) est polarisée en tension.

## Claims

1. Photovoltaic infrared radiation detector comprising, on a front face of a substrate (1) transparent to the radiation considered, a stack of layers (3-6) made of absorbent semi-conducting materials, a network of channels (7) confining pixels (2, 2', 2") in the stack of layers (3-6), and an insulating layer (8) covering at least the bottom and side walls of the channels (7), detector **characterized in that** it comprises an electrically conducting layer (10) covering the insulating layer (8) on the bottom and on the side walls of the channels (7) and electrically independent from the semi-conducting materials so as to be totally electrically insulated from the semi-conducting materials by said insulating layer (8).

2. Detector according to claim 1, **characterized in that** the electrically conducting layer (10) is connected to a connection terminal (11').

3. Detector according to one of claims 1 and 2, **characterized in that** the insulating layer (8) also covers, at least partially, the front face of at least one pixel (2').

4. Detector according to claim 3, **characterized in that** the electrically conducting layer (10) covers at least a part of the insulating layer (8) covering, at least partially, the front face of a pixel (2').

5. Detector according to claim 4, **characterized in that** a connection terminal (11') is situated on the electrically conducting layer (10), on the front face of a pixel (2').

6. Detector according to any one of claims 1 to 5, **characterized in that** the stack of absorbent semi-conducting material layers (3-6) forms at least two PN junctions having different cutoff wavelengths stacked on the front face of the substrate (1) in increasing cutoff wavelength order.

7. Detector according to any one of claims 1 to 6, **characterized in that** the stack of semi-conducting material layers (3-6) comprises, between two PN junctions, an additional semi-conducting layer (13) presenting a larger semi-conducting gap than the gaps of said semi-conducting materials.

8. Detector according to any one of claims 1 to 7, **characterized in that** the semi-conducting materials are chosen from CdHgTe, InSb, InGaAs.

9. Detector according to any one of claims 1 to 8, **characterized in that** the electrically conducting layer (10) comprises a stack of several layers.

10. Detector according to any one of claims 1 to 9, **characterized in that** the electrically conducting layer (10) comprises at least one material chosen from Au, Ti, Al, Pt, Pd.

11. Process for achieving a photovoltaic infrared radiation detector according to any one of the claims 1 to 10, comprising deposition on a front face of a substrate (1), transparent to the radiation considered, of a stack of layers (3-6) made of absorbent semi-conducting materials, confinement of a network of pixels (2, 2', 2") by etching channels (7) in the stack of semi-conducting material layers (3-6), deposition of an insulating layer (8) covering at least the bottom and the side walls of the channels (7), and deposition of an electrically conducting layer (10) covering the insulating layer (8) on the bottom and the side walls of the channels (7) confining at least a part of the pixels (2, 2', 2").

12. Process for using a photovoltaic infrared radiation detector according to any one of the claims 1 to 10, **characterized in that** the electrically conducting layer (10) is voltage polarized.

## Patentansprüche

1. Photovoltaischer Infrarotdetektor, der auf einer Vorderseite eines für die betrachtete Strahlung transparenten Substrats (1) eine Aufschichtung von Schichten (3-6) aus halbleitenden, absorbierenden Materialien; ein Netzwerk aus Kanälen (7), die in der Aufschichtung von Schichten (3-6) Pixel (2, 2', 2") begrenzen, sowie eine isolierende Schicht (8) umfasst, die mindestens den Boden und die Seitenfächen der Kanäle (7) bedeckt, Detektor, der **dadurch gekennzeichnet ist, dass** er eine elektrisch leitende Schicht (10) umfasst, welche die isolierende (8) Schicht am Boden und an den Seitenflächen der Kanäle (7) bedeckt und elektrisch unabhängig ist von den halbleitenden Materialien, sodass sie durch die genannte isolierende Schicht (8) elektrisch vollkommen von den halbleitenden Materialien isoliert ist.

2. Detektor nach Anspruch 1, **dadurch gekennzeichnet, dass** die elektrisch leitende Schicht (10) an eine Anschlussklemme (11') gelegt ist.

3. Detektor nach einem der Ansprüche 1 und 2, **dadurch gekennzeichnet, dass** die isolierende Schicht (8) ebenfalls zumindest teilweise die Vorderseite mindestens eines Pixels (2') bedeckt.

4. Detektor nach Anspruch 3, **dadurch gekennzeichnet, dass** die elektrisch leitende Schicht (10) ebenfalls zumindest einen Teil der isolierenden Schicht (8) bedeckt, die zumindest teilweise die Vorderseite eines Pixels (2') bedeckt.

5. Detektor nach Anspruch 4, **dadurch gekennzeichnet, dass** sich eine Anschlussklemme (11') auf der elektrisch leitenden Schicht (10) auf der Vorderseite eines Pixels (2') befindet.

6. Detektor nach einem der Ansprüche 1 bis 5, **dadurch gekennzeichnet, dass** die Aufschichtung der Schichten (3-6) aus halbleitenden, absorbierenden Materialien mindestens zwei PN-Übergänge bildet, die unterschiedliche Unterbrechungswellenlängen aufweisen und auf der Vorderseite des Substrats (1) in aufsteigender Folge der Unterbrechungswellenlänge aufgeschichtet sind.

7. Detektor nach einem der Ansprüche 1 bis 6, **dadurch gekennzeichnet, dass** die Aufschichtung der Schichten (3-6) aus halbleitenden Materialien zwischen zwei PN-Übergängen eine zusätzliche halbleitende Schicht (13) aufweist, die einen halbleitenden Spalt aufweist, der größer ist als die Spalte der genannten halbleitenden Materialien.

8. Detektor nach einem der Ansprüche 1 bis 7, **dadurch gekennzeichnet, dass** die halbleitenden Materialien ausgewählt sind aus CdHgTe, InSb, InGaAs.

9. Detektor nach einem der Ansprüche 1 bis 8, **dadurch gekennzeichnet, dass** die elektrisch leitende Schicht (10) eine Aufschichtung aus mehreren Schichten umfasst.

10. Detektor nach einem der Ansprüche 1 bis 9, **dadurch gekennzeichnet, dass** die elektrisch leitende Schicht (10) mindestens ein Material umfasst, das ausgewählt ist aus Au, Ti, Al, Pt, Pd.

11. Herstellungsverfahren für einen photovoltaischen Infrarotdetektor nach einem der Ansprüche 1 bis 10, das das Aufbringen einer Aufschichtung von Schichten (3-6) aus absorbierenden, halbleitenden Materialien auf eine Vorderseite eines Substrats (1), das für die betrachtete Strahlung transparent ist, die Begrenzung eines Pixelrasters (2, 2', 2") durch Ätzen von Kanälen (7) in der Aufschichtung von Schichten (3-6) aus halbleitenden Materialien, das Aufbringen einer isolierenden Schicht (8), die zumindest den Boden und die Seitenflächen der Kanäle (7) bedeckt, und das Aufbringen einer elektrisch leitenden Schicht (10), welche die isolierende Schicht (8) am Boden und an den Seitenflächen der Kanäle (7) bedeckt, die mindestens einen Teil der Pixel (2, 2', 2") begrenzen, umfasst.

12. Verfahren zur Herstellung eines photovoltaischen Infrarotdetektors nach einem der Ansprüche 1 bis 10, **dadurch gekennzeichnet, dass** die elektrisch leitende Schicht (10) spannungspolarisiert ist.
